# EUROPEAN PATENT SPECIFICATION

(11) **EP 2 896 723 B1**
(45) Date of publication and mention of the grant of the patent: **09.08.2017**
(21) Application number: 13837186.9
(22) Date of filing: 11.09.2013
(51) Int. Cl.: C25D 3/56, C25D 7/06, C25D 5/48, C23F 11/00, H05K 3/38

(54) **METHOD FOR SURFACE-TREATING COPPER FOIL AND COPPER FOIL SURFACE-TREATED THEREBY**
VERFAHREN ZUR OBERFLÄCHENBEHANDLUNG KUPFERFOLIE UND OBERFLÄCHENBEHANDELTES DADURCH
PROCÉDÉ DE TRAITEMENT DE SURFACE DE FEUILLE DE CUIVRE ET FEUILLE DE CUIVRE AINSI TRAITÉE

(30) Priority: 12.09.2012 KR 20120100953; 10.09.2013 KR 20130108233
(43) Date of publication of application: 22.07.2015
(73) Proprietor: Doosan Corporation, Seoul 100-730 (KR)
(72) Inventor: MOON, Hong Gi, Yongin-si Gyeonggi-do, 16858 (KR)
(74) Representative: Isarpatent
(86) International application number: PCT/KR2013/008195
(87) International publication number: WO 2014/042412

(56) References cited:
- JP-A- 2006 028 635
- KR-A- 20030 039 937
- KR-A- 20080 067 277
- KR-A- 20090 065 019
- KR-A- 20090 104 289
- KR-B1- 100 857 311
- US-A1- 2004 157 080
- US-A1- 2007 071 999
- US-A1- 2011 171 486

## Description

### [Technical Field]

The present invention relates to a method for surface-treating a copper foil (rolled copper foil), and a rolled copper foil surface-treated by the method.

### [Background Art]

In accordance with industrial development, use of a printed circuit board is increased in each industrial region. Particularly, recently, a demand for a flexible printed circuit board as well as a rigid printed circuit board has been rapidly increased. The printed circuit board is generally manufactured by forming a plating layer on a copper clad laminate (CCL) and then patterning a circuit on the formed plating layer.

As a copper foil used in the copper clad laminate a rolled copper foil is used. Whenever the term copper foil is used in the following in regard to the present invention, it is to be understood as a rolled copper foil unless explicitly stated otherwise. The described electrolytic copper foil is manufactured by immersing a drum in an electrolyte, performing electroplating to prepare a copper foil, and then surface-treating the copper foil, and the rolled copper foil is manufactured by rolling a copper ingot on a rolling roller to manufacture a copper foil and then surface-treating the copper foil.

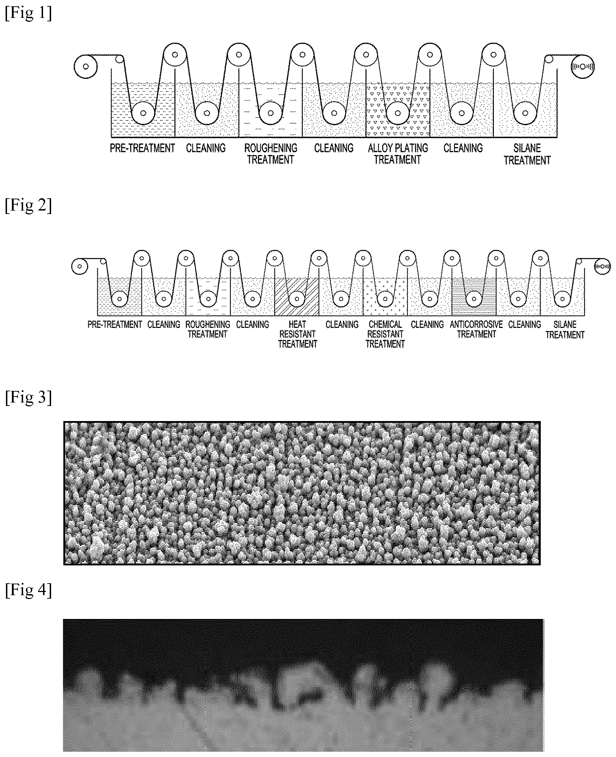

When the described electrolytic copper foil or the rolled copper foil is manufactured, in the related art, surface-treatment is performed by a complicated process such as pre-treatment, roughening treatment, heat resistant treatment, chemical resistant treatment, anticorrosive treatment, and silane treatment (refer to FIG. 2). However, there is a problem in that manufacturing efficiency of the copper foil is reduced according to performing surface-treatment by the aforementioned complicated process. That is, a loss of a material (the copper foil of a basic metal) and a process is increased according to the progression of the surface-treatment of various steps which reduces total manufacturing efficiency of the copper foil. Further, there is a problem in that whenever one treatment process is finished and the copper foil is cleaned (washed), pollutants and waste water are generated, which is not environmentally-friendly.
US 2011/171486 A1 teaches a copper foil with a columnar layer and a granular layer, thereby reducing transmission loss at high frequency applications and a method and apparatus for producing said foil.
US 2004/157080 A1 teaches a copper foil which is subjected to roughening treatment for fine pattern printed circuits and a method for producing said foil. US 2007/071999 A1 teaches a nickel plating solution and its preparation method, a nickel plating method and printed wiring board copper foil.
JP 2006 028635 A teaches a method for manufacturing copper foil with an excellent strength of adhesion to a substrate and high heat resistance.
KR 2008 0067277 A teaches a copper foil laminated structure to improve reliability of electronic equipment by applying a silane coupling agent onto a surface of a copper foil. KR 100 857 311 B1 teaches an electrolytic copper foil and a surface treatment method for the same to be suitable for a PCB (Printed Circuit Board).

### [Disclosure]

### [Technical Problem]

The present invention has been made in an effort to provide a method for surface-treating a copper foil, in which a surface-treating process is simple.

Further, the present invention has been made in an effort to provide a copper foil surface-treated by the method, and a copper clad laminate including the copper foil.

### [Technical Solution]

An exemplary embodiment of the present invention provides a method for surface-treating a copper foil, the method including steps of: a) forming a nodule on a surface of the rolled copper foil; b) introducing the rolled copper foil having thereon the nodule to a plating solution including first, second, and third metals to perform alloy plating; and c) applying the alloy plated copper foil with a silane coupling agent.

The first metal is at least one selected from the group consisting of nickel (Ni), cobalt (Co), niobium (Nb), tungsten (W), copper (Cu), zinc (Zn), and molybdenum (Mo).

Also, the second metal is zinc (Zn) or tin (Sn).

Also, the third metal is chrome (Cr).

Meanwhile, the present invention provides the surface-treated copper foil and a copper clad laminate including the same.

### [Brief Description of The Drawings]

FIG. 1 illustrates a surface-treatment process of a copper foil of the present invention.
FIG. 2 illustrates a surface-treatment process of a copper foil of the related art.
FIG. 3 is an image obtained by photographing a surface of a copper foil surface-treated by a method of the present invention.
FIG. 4 is an image obtained by photographing a cross-section of the copper foil surface-treated by the method of the present invention.

### [Best Mode]

Hereinafter, the present invention will be described with reference to the drawings.

### 1. Method for surface-treating copper foil

### a) Formation of nodule

Referring to FIG. 1, in the surface-treating method of the present invention, first, a nodule is formed on a surface of the copper foil. Formation of the nodule on the copper foil is performed to increase mechanical adhesion strength with a resin layer when a copper clad laminate is manufactured. Herein, a method for forming the nodule on the copper foil is not particularly limited as long as the method is a method publicly known in the related art, but non-limiting examples thereof may include roughening treatment, etching treatment (chemical etching or electrolytic etching), and oxidation treatment (Brown oxide, Black oxide) methods and the like. Among the methods, it is preferable to use roughening treatment that is useful to form the nodule.

Specifically, in the roughening treatment method, after the copper foil is introduced to an electrolyte including metals at least one selected from the group consisting of copper (Cu), nickel (Ni), cobalt (Co), iron (Fe), tin (Sn), and arsenic (As), plating is performed at a predetermined current density or more to generate a metal nucleus on the surface of the copper foil and capsulate the metal nucleus. In this case, a process of capsulating the generated metal nucleus is performed at a temperature that is higher than a temperature at which the metal nucleus is generated, and the electrolyte having a concentration that is larger (thicker) than a concentration of the electrolyte, at which the metal nucleus is generated, is used. Herein, a metal used to form the nodule by roughening treatment is mostly copper (Cu), and the other residual metal is used as an additive to control the shape of the nodule. The size (roughness or the height of the nodule) of the nodule formed by this roughening treatment is not particularly limited, but in consideration of adhesion strength with the resin layer and etching of the copper foil for forming a wire pattern, it is preferable that the size be 2 to 20 µm.

Meanwhile, the copper foil used to form the nodule is a copper foil of a basic metal, and a matter manufactured by immersing a drum in the electrolyte and performing electroplating, or a matter manufactured by rolling a copper ingot by a rolling roller may be used. Herein, the surface-treating method of the present invention may further include a step of washing the copper foil of the basic metal.

The copper foil manufactured by immersing the drum in the electrolyte and performing electroplating has a clean surface, but in the copper foil manufactured by rolling the copper ingot by the rolling roller, rolling oil is used during rolling, and thus rolling oil and/or an oxide film may exist on the surface of the copper foil. Accordingly, the surface-treating method of the present invention may further include, before the nodule is formed, a washing (pre-treatment) step for removing rolling oil and/or the oxide film existing in the copper foil.

Herein, a method for washing the copper foil is not particularly limited as long as the method is a method publicly known in the related art, but non-limiting examples thereof may selectively include degreasing, pickling, and polishing. The degreasing is performed to remove a residual material of rolling oil existing in the copper foil, and alkali degreasing, acid degreasing, or electrolytic degreasing may be applied. Further, the pickling and polishing are performed to remove the oxide film existing in the copper foil, and it is preferable to perform treatment after the degreasing is removed.

### b) Alloy plating

Next, the copper foil where the nodule is formed is introduced to a plating solution including the first, second, and third metals to perform alloy plating. An alloy plating layer is formed on the surface of the nodule formed in the copper foil according to the aforementioned alloy plating. Since the first metal, the second metal, and the third metal are a metal having heat resistance, chemical resistance, an anticorrosive property, and the like, there is secured an effect where the copper foil of the present invention is subjected to heat resistant treatment, chemical resistant treatment, and anticorrosive treatment through one alloy plating process.

As described above, since in the present invention, the surface of the copper foil is treated by a shortened process, as compared to a surface-treating method of the related art where heat resistant treatment, chemical resistant treatment, and anticorrosive treatment are performed while being divided into individual processes, surface-treating process efficiency may be increased (a reduction in loss ratio of the copper foil of the basic metal), and a generation amount of pollutants and waste water according to cleaning (washing) may be reduced.

The first metal included in the plating solution for alloy plating is a metal having heat resistance and is at least one selected from the group consisting of nickel (Ni), cobalt (Co), niobium (Nb), tungsten (W), copper (Cu), zinc (Zn), and molybdenum (Mo). Specifically, it is at least one selected from the group consisting of nickel (Ni), cobalt (Co), and molybdenum (Mo). The second metal is a metal having chemical resistance, it is zinc (Zn) or tin (Sn). The third metal is a metal having the anticorrosive property, it is chrome (Cr).

Herein, a concentration ratio of the first metal, the second metal, and the third metal included in the plating solution (a content ratio of the first metal, the second metal, and the third metal in the plating solution, g/ℓ) is in consideration of heat resistance, chemical resistance, and the anticorrosive property, the concentration ratio is 0.5 to 3 : 0.5 to 3 : 2 to 7 and more preferably 1 to 2.5 : 1 to 1.5 : 3 to 5.

Meanwhile, a method of introducing the copper foil to the plating solution to perform alloy plating is not particularly limited, but it is preferable to perform electrolytic plating. Specifically, the first metal, the second metal, and the third metal are introduced to an acidic or alkaline electrolyte to prepare the plating solution, the copper foil where the nodule is formed is introduced to the prepared plating solution, and then electrolytic plating is performed to form an alloy plating layer. Herein, a temperature and a time of electrolytic plating are not particularly limited, but it is preferable that the temperature is 15 to 70°C (preferably 25 to 50°C) and the time is 2 to 8 seconds. Also, a current density of electrolytic plating is not particularly limited, but it is preferable to adjust the current density to 0.2 to 20 A/dm², and it is more preferable to adjust the current density to 0.5 to 5 A/dm² so that the alloy plating layer is uniformly formed on the nodule of the copper foil.

### c) Application of silane coupling agent

After alloy plating is performed, when the copper clad laminate is manufactured, in order to increase chemical adhesion strength with the resin layer, a silane coupling agent is applied (coated) on the alloy plated copper foil. That is, in order to increase adhesion strength between the alloy plating layer of the copper foil and the resin layer, the silane coupling agent is applied on the alloy plating layer.

The silane coupling agent is not particularly limited but may be used as long as the silane coupling agent is a material publicly known in the related art, but non-limiting examples thereof may include 3-aminopropyltriethoxysilane, 3-aminopropyltrimethoxysilane, N-2-(aminoethyl)-3-aminopropyltriethoxysilane, N-2-(aminoethyl)-3-aminopropylmethyldimethoxysilane, N-2-(aminoethyl)-3-aminopropyltrimethoxysilane, N-phenyl-3-aminopropyltrimethoxysilane, N-(vinylbenzyl)-2-aminoethyl-3-aminopropyltrimethoxysilane, 3-(N-styrylmethyl-2-aminoethylamino)propyltrimethoxysilane, bis(2-hydroxyethyl)-3-aminopropyltriethoxysilane, N-methylaminopropyltrimethoxysilane, N-(3-acryloxy-2-hydroxypropyl)-3-aminopropyltriethoxysilane, 4-aminobutyltriethoxysilane, (aminoethylaminomethyl)phenethyltrimethoxysilane, N-(2-aminoethyl-3-aminopropyl)tris(2-ethylhexoxy)silane, 6-(aminohexylaminopropyl)trimethoxysilane, aminophenyltrimethoxysilane, 3-(1-aminopropoxy)-3,3-dimethyl-1-prophenyltrimethoxysilane, 3-aminopropyltris(methoxyethoxyethoxy)silane, ω-aminoundecyltrimethoxysilane, 3-(2-N-benzylaminoethylaminopropyl)trimethoxysilane, bis(2-hydroxyethyl)-3-aminopropyltriethoxysilane, 3-glycidoxypropyltriethoxysilane, 3-glycidoxypropylmethyldiethoxysilane, 3-tricidoxypropyltrimethoxysilane, 3-glycidoxypropylmethyldimethoxysilane, 2-(3,4-epoxycyclohexyl)ethyltrimethoxysilane, vinyltriacetoxysilane, vinyltriethoxysilane, vinyltrimethoxysilane, vinyltriisopropoxysilane, vinyltrichlorosilane, allyltrimethoxysilane, diallyldimethylsilane, 3-methacryloxypropyltriethoxysilane, 3-methacryloxypropylmethyldiethoxysilane, 3-methacryloxypropyltrimethoxysilane, 3-methacryloxypropylmethyldimethoxysilane, 3-acryloxypropyltrimethoxysilane, 3-mercaptopropyltrimethoxysilane, 3-mercaptopropyltriethoxysilane, 3-mercaptopropylmethyldimethoxysilane, 3-mercaptopropyltrimethoxysilane, N-(1,3-dimethylbutylidene)-3-aminopropyltriethoxysilane, p-styryltrimethoxysilane, 3-ureidepropyltriethoxysilane, 3-chloropropyltrimethoxysilane, 3-isocyanatepropyltriethoxysilane, and the like.

A treatment method by the silane coupling agent is not particularly limited, but may be performed by a process where the silane coupling agent is sprayed at room temperature (specifically 20 to 30°C) at a concentration of 0.1 to 10 g/ℓ on the copper foil where the alloy plating layer is formed (or the copper foil is deposited in the silane coupling agent for 0.5 to 5 seconds) to be dried at 100 to 250°C.

Meanwhile, in the case where the copper foil is surface-treated through the aforementioned process, it is preferable that cleaning be performed between the prior process and the rear process to prevent the electrolytes of the prior process and the rear process from being mixed.

### 2. Copper foil and copper clad laminate including the same

The present invention provides the copper foil manufactured through the surface-treatment process, and the copper clad laminate including the same. In this case, the copper foil manufactured through the surface-treatment process is a rolled copper foil. This is because in the case where the surface-treatment process of the present invention is applied to the rolled copper foil instead of a described electrolytic copper foil, a loss (manufacturing prime cost) of the copper foil may be reduced. Specifically, in the case where a rolled copper foil is treated by a surface-treatment process of the related art (refer to FIG. 2), the loss ratio is 15% or more, but in the case where the rolled copper foil is treated by the surface-treatment process of the present invention, the loss ratio may be reduced to 5 to 10%.

Meanwhile, a structure of the copper clad laminate of the present invention including the copper foil is not particularly limited, but the copper clad laminate may have various structures based on a form where the copper foil and the resin layer are combined. In this case, a material used as the resin layer is not particularly limited as long as the material is a material publicly known in the art (for example, polyimide, epoxy).

The copper clad laminate may be applied to various industrial fields, and particularly, may be usefully applied to manufacture a flexible circuit board.

Hereinafter, the present invention will be described in more detail with reference to Examples.

### [Example 1] Manufacturing of copper clad laminate

### 1) Surface-treatment of copper foil

The rolled copper foil having the thickness of 200 µm was introduced to the degreasing solution (NaOH at the concentration of 5 g/ℓ), was deposited at 40 to 50°C for 10 seconds, and was subjected to pickling by the method publicly known in the related art to wash (pre-treat) the surface. The washed rolled copper foil was introduced to the electrolyte including copper (Cu) to be subjected to roughening treatment and thus form the nodule on the surface thereof. In this case, the conditions of the electrolyte used when the copper nucleus is generated and the electrolyte used when the copper nucleus is capsulated are described in the following Table 1.

Next, in order to form the alloy plating layer on the surface of the nodule formed in the copper foil, the plating solution (sulfuric acid was used as the electrolyte) and plating condition of the following Table 2 were applied to perform electrolytic plating.

Next, the copper foil subjected to alloy plating treatment was deposited in N-2-(aminoethyl)-3-aminopropyltriethoxy silane at the concentration of 2 g/ℓ for about 1 second, and then left in the oven at 180°C for 1 minute to be dried. The surface and the cross-section of the copper foil where the surface-treatment was finished were confirmed by the scanning electron microscope (refer to FIG. 3) and the optical microscope (refer to FIG. 4), respectively.

The structure of the device used during surface-treatment of the copper foil is illustrated in FIG. 1.

### 2) Manufacturing of copper clad laminate

The copper foil manufactured through the aforementioned process was pressed with the resin layer (DS-7402) under the vacuum at 180°C to manufacture the copper clad laminate.

**[Table 1]**

| Step | Copper concentration | Sulfuric acid concentration | Electrolyte temperature |
|---|---|---|---|
| Generation of copper nucleus | 10 g/ℓ | 80 g/ℓ | 25°C |
| Capsulation of copper nucleus | 45 g/ℓ | 80 g/ℓ | 40°C |

### [Examples 2 to 11, C4, C7, C8 and C9]

The copper clad laminate was manufactured through the same process as Example 1, except that when the alloy plating layer was formed, the plating solution (sulfuric acid was used as the electrolyte) and plating condition of the following Table 2 were applied.

### [Comparative Example 1]

The copper clad laminate was manufactured through the same process as Example 1, except that when the copper foil where the nodule was formed was introduced to the electrolyte each including Ni, Zn, and Cr and the current density was adjusted to separately perform Ni plating, Zn plating, and Cr plating. Herein, the structure of the device used during surface-treatment of the copper foil is illustrated in FIG. 2.

### [Comparative Example 2]

The copper clad laminate was manufactured through the same process as Example 1, except that alloy plating treatment was not performed (only formation of the nodule and application of the silane coupling agent were performed).

### [Comparative Examples 3 to 10]

The copper clad laminate was manufactured through the same process as Comparative Example 1, except that when the alloy plating layer was formed, the plating solution (sulfuric acid was used as the electrolyte) and plating condition of the following Table 2 were applied.

**[Table 2]**

| | Kind of metal | | Metal concentration (g/ℓ) | Current density (A/dm²) | Plating time (sec) | Metal electrodeposition amount (mg/m²) |
|---|---|---|---|---|---|---|
| Example 1 | First metal | Ni | 2 | 2.5 | 5 | 22.5 |
| | Second metal | Zn | 1 | | | 25.3 |
| | Third metal | Cr | 5 | | | 25.2 |
| Example 2 | First metal | Co | 2.5 | 2.5 | 5 | 18.7 |
| | Second metal | Zn | 1 | | | 20.3 |
| | Third metal | Cr | 5 | | | 27.3 |
| Example 3 | First metal | Ni | 2 | 2.5 | 5 | 25.3 |
| | Second metal | Sn | 1.5 | | | 27.8 |
| | Third metal | Cr | 5 | | | 22.3 |
| Comparative Example C4 | First metal | Ni | 2 | 2.5 | 5 | 20.7 |
| | Second metal | Zn | 1 | | | 23.5 |
| | Third metal | Mo | 3 | | | 27.3 |
| Example 5 | First metal | Ni | 1 | 2.5 | 5 | 13.5 |
| | First metal | Co | 1.5 | | | 16.7 |
| | Second metal | Zn | 1 | | | 18.5 |
| | Third metal | Cr | 5 | | | 19.8 |
| Example 6 | First metal | W | 2 | 2.5 | 5 | 25.1 |
| | Second metal | Sn | 1.5 | | | 26.9 |
| | Third metal | Cr | 5 | | | 28.9 |
| Comparative Example C7 | First metal | Ni | 10 | 2.5 | 5 | 98.7 |
| | Second metal | Zn | 1 | | | 22.4 |
| | Third metal | Cr | 5 | | | 23.6 |
| Comparative Example 8 | First metal | Ni | 2 | 2.5 | 5 | 19.8 |
| | Second metal | Zn | 5 | | | 87.6 |
| | Third metal | Cr | 5 | | | 21.2 |
| Comparative Example C9 | First metal | Ni | 2 | 2.5 | 5 | 23.2 |
| | Second metal | Zn | 1 | | | 18.5 |
| | Third metal | Cr | 25 | | | 127.2 |
| Example 10 | First metal | Ni | 2 | 2.5 | 25 | 98.7 |
| | Second metal | Zn | 1 | | | 107.5 |
| | Third metal | Cr | 5 | | | 123.7 |
| Example 11 | First metal | Ni | 2 | 2.5 | 1.5 | 7.2 |
| | Second metal | Zn | 1 | | | 8.6 |
| | Third metal | Cr | 5 | | | 7.8 |
| Comparative Example 1 | First treatment | Ni | 2 | 0.8 | 5 | 13.5 |
| | Second treatment | Zn | 1 | 0.8 | 5 | 22.5 |
| | Third treatment | Cr | 5 | 0.8 | 5 | 26.4 |
| Comparative Example 3 | First treatment | Ni | 10 | 0.8 | 5 | 72.5 |
| | Second treatment | Zn | 1 | 0.8 | 5 | 21.8 |
| | Third treatment | Cr | 5 | 0.8 | 5 | 24.7 |
| Comparative Example 4 | First treatment | Ni | 2 | 0.8 | 5 | 15.2 |
| | Second treatment | Zn | 5 | 0.8 | 5 | 47.8 |
| | Third treatment | Cr | 5 | 0.8 | 5 | 25.3 |
| Comparative Example 5 | First treatment | Ni | 2 | 0.8 | 5 | 12.7 |
| | Second treatment | Zn | 1 | 0.8 | 5 | 20.8 |
| | Third treatment | Cr | 25 | 0.8 | 5 | 107.8 |
| Comparative Example 6 | First treatment | Ni | 2 | 0.8 | 25 | 57.3 |
| | Second treatment | Zn | 1 | 0.8 | 25 | 105.6 |
| | Third treatment | Cr | 5 | 0.8 | 25 | 112.5 |
| Comparative Example 7 | First treatment | Ni | 2 | 0.8 | 2 | 5.2 |
| | Second treatment | Zn | 1 | 0.8 | 2 | 6.5 |
| | Third treatment | Cr | 5 | 0.8 | 2 | 7.1 |
| Comparative Example 8 | First treatment | Ni | 2 | 0.8 | 25 | 55.7 |
| | Second treatment | Zn | 1 | 0.8 | 5 | 21.4 |
| | Third treatment | Cr | 5 | 0.8 | 5 | 27.3 |
| Comparative Example 9 | First treatment | Ni | 2 | 0.8 | 5 | 14.3 |
| | Second treatment | Zn | 1 | 0.8 | 25 | 72.3 |
| | Third treatment | Cr | 5 | 0.8 | 5 | 25.4 |
| Comparative Example 10 | First treatment | Ni | 2 | 0.8 | 5 | 11.9 |
| | Second treatment | Zn | 1 | 0.8 | 5 | 23.3 |
| | Third treatment | Cr | 5 | 0.8 | 25 | 98.7 |
| * The metal concentration is a concentration of metal ions | | | | | | |

### [Experimental Example]

Physical properties of the copper clad laminates manufactured in Examples 1 to 11 and Comparative Examples 1 to 10, C4, C7, C8 and C9 were evaluated by the following method, and the results are described in the following Tables 3 and 4 (the physical properties were evaluated as 'good' at 4.00 kgf/cm or more).
1. Adhesion strength A: The copper clad laminate was cut in the width of 2 cm, taped by the tape (acid resistance), and etched in the etching solution (sulfuric acid + hydrogen peroxide) to manufacture the specimen, and 90° adhesion strength was then measured by using the universal material testing machine (UTM) (adhesion strength A was evaluated as 'good' at 4.00 kgf/cm or more).
2. Adhesion strength B: The specimen manufactured to measure adhesion strength A was baked in the oven at 180°C for 24 hours, and 90° adhesion strength was then measured by using the universal material testing machine (UTM).
3. Heat resistance: After the temperature of the solder pot was set to 288°C, if the temperature of the solder pot reached the set temperature, the copper clad laminate was cut in the size of 5 × 5 cm to manufacture the specimen, the specimen was allowed to float in the solder port, and the time until the specimen is swollen was measured in the second unit. When the time was measured to be 20 seconds or more, heat resistance was evaluated as 'OK', and when the time was measured to be less than 20 seconds, heat resistance was evaluated as 'NG'.
4. Hydrochloric acid resistance (chemical resistance): The copper clad laminate was cut in the width of 2 cm, the circuit of the copper foil of 1 mm was formed by using the tape or the photoresist, adhesion strength was measured (C), followed by deposition in the 10% hydrochloric acid solution for 1 hour, cleaning, and drying, and adhesion strength was then measured (D) to exhibit the reduction in adhesion strength as the percentage [{(C - D)/C} × 100].
5. Oxidation property: After the copper clad laminate was left in the oven at 180°C for 1 hour, whether oxidation or the stain occurred or not was confirmed by the naked eye, and when there was no change, the oxidation property was evaluated as 'OK', and when oxidation or the stain occurred, the oxidation property was evaluated as 'NG'.
6. Residual metal test: After the copper clad laminate was etched in the etching solution (sulfuric acid + hydrogen peroxide) for 10 minutes and dried in the oven at 150°C for 10 minutes, electroless gold plating was performed to confirm whether the metal component remained on the surface.
7. Loss ratio: The weight W₁ of the copper foil of the basic metal before surface-treatment was measured, and the weight W₂ of the usable copper foil after surface-treatment was measured to measure the loss ratio [{(W₁ - W₂)/W₁} × 100].

**[Table 3]**

| | Adhesion strength A (kgf/cm) | Adhesion strength B (kgf/cm) | Heat resistance (288°C, 20 seconds) | Hydrochloric acid resistance (%) |
|---|---|---|---|---|
| Example 1 | 4.48 | 4.32 | OK | 3% |
| Example 2 | 4.78 | 4.85 | OK | 3% |
| Example 3 | 5.02 | 4.88 | OK | 5% |
| Comparative Example C4 | 4.83 | 4.53 | OK | 2% |
| Example 5 | 4.85 | 4.65 | OK | 3% |
| Example 6 | 4.72 | 4.63 | OK | 1% |
| Comparative Example C7 | 4.69 | 4.55 | OK | 2.0% |
| Comparative Example C8 | 4.57 | 4.42 | OK | 1.3% |
| Comparative Example C9 | 4.59 | 4.43 | OK | 1.9% |
| Example 10 | 4.47 | 4.39 | OK | 5.1% |
| Example 11 | 4.53 | 4.48 | OK | 9.2% |
| Comparative Example 1 | 4.75 | 4.61 | OK | 3% |
| Comparative Example 2 | 3.89 | 1.93 | NG | 17% |
| Comparative Example 3 | 4.71 | 4.68 | OK | 1.1% |
| Comparative Example 4 | 4.45 | 4.28 | OK | 2.4% |
| Comparative Example 5 | 4.75 | 4.62 | OK | 1.3% |
| Comparative Example 6 | 4.54 | 4.47 | OK | 3.7% |
| Comparative Example 7 | 4.74 | 4.12 | OK | 11.1% |
| Comparative Example 8 | 4.65 | 4.49 | OK | 2.2% |
| Comparative Example 9 | 4.32 | 4.07 | OK | 1.1% |
| Comparative Example 10 | 4.57 | 4.32 | OK | 3.2% |

**[Table 4]**

| | Oxidation property (180°C, 1 hr) | Residual metal test | Loss ratio (%) |
|---|---|---|---|
| Example 1 | OK | No remaining | 10 |
| Example 2 | OK | No remaining | 10 |
| Example 3 | OK | No remaining | 10 |
| Comparative Example C4 | OK | Remaining in a small amount | 10 |
| Example 5 | OK | No remaining | 10 |
| Example 6 | OK | Remaining in a small amount | 10 |
| Comparative Example C7 | OK | Remaining in a small amount | 10 |
| Comparative Example C8 | OK | No remaining | 10 |
| Comparative Example C9 | OK | Remaining in a small amount | 10 |
| Example 10 | OK | Remaining in a small amount | 10 |
| Example 11 | OK | No remaining | 10 |
| Comparative Example 1 | OK | No remaining | 16 |
| Comparative Example 2 | NG | No remaining | 16 |
| Comparative Example 3 | OK | Remaining in a large amount | 16 |
| Comparative Example 4 | OK | Remaining in a small amount | 16 |
| Comparative Example 5 | OK | Remaining in a large amount | 16 |
| Comparative Example 6 | OK | Remaining in a large amount | 16 |
| Comparative Example 7 | OK | No remaining | 16 |
| Comparative Example 8 | OK | Remaining in a large amount | 16 |
| Comparative Example 9 | OK | Remaining in a small amount | 16 |
| Comparative Example 10 | OK | Remaining in a large amount | 16 |

Reviewing Tables 3 and 4, it could be seen that the copper clad laminate of Examples 1 to 11 including the copper foil treated by the surface-treatment method of the present invention had physical properties that were the same as or better than those of the copper clad laminate of Comparative Examples 1 to 10, C4, C7, C8 and C9. Further, it could be confirmed that in the case where the copper foil was treated by the surface-treatment method of the present invention, the loss ratio of the copper foil of the basic metal was reduced.

Meanwhile, in the case where the board is manufactured by the copper clad laminate where remaining of the metal was confirmed through the residual metal test, reliability of the board may be reduced. Accordingly, in the alloy treatment process of the present invention, it is preferable to appropriately adjust the plating solution and plating condition (because in the case where the alloy plating layer is excessively formed in the copper foil, a possibility of remaining of the residual metal is increased).

### [Industrial Applicability]

In the method of surface-treating the copper foil according to the present invention, heat resistant treatment, chemical resistant treatment, and anticorrosive treatment that have been performed by individual processes may be solved by one alloy plating treatment, and thus the loss of the material (the copper foil of the basic metal) and the process may be reduced. Also, the surface-treatment process may be shortened to reduce generation of pollutants and waste water according to cleaning (washing) and thus minimize environmental pollution.

## Claims

1. A method for surface-treating a rolled copper foil, the method comprising steps of:
a) forming a nodule on a surface of the rolled copper foil;
b) introducing the copper foil having thereon the nodule to a plating solution including first metal having heat resistance, second metal having chemical resistance, and third metal having an anticorrosive property to perform alloy plating; and
c) applying the alloy plated copper foil with a silane coupling agent,
wherein first metal is at least one selected from the group consisting of nickel (Ni), cobalt (Co), niobium (Nb), copper (Cu), zinc (Zn), and molybdenum (Mo),
the second metal is zinc (Zn) or tin (Sn),
the third metal is chrome (Cr), and
a concentration ratio of the first metal, the second metal, and the third metal included in the plating solution is 0.5 to 3 : 0.5 to 3 : 2 to 7.

2. The method of claim 1, wherein the step a) further includes, before the nodule is formed, washing the surface of the copper foil.

3. A rolled copper foil surface-treated by the method of any one of claims 1 to 2.

4. A copper clad laminate comprising:
the rolled copper foil of claim 3.

## Patentansprüche

1. Verfahren zur Oberflächenbehandlung einer gewalzten Kupferfolie, wobei das Verfahren die folgenden Schritte umfasst:
a) Bilden eines Knötchens auf einer Oberfläche der gewalzten Kupferfolie;
b) Einführen der Kupferfolie, auf der sich das Knötchen befindet, in eine Plattierungslösung, die ein erstes Metall mit einer Wärmebeständigkeit, ein zweites Metall mit einer chemischen Beständigkeit und ein drittes Metall mit einer Korrosionsschutzeigenschaft enthält, zur Durchführung einer Legierungsplattierung; und
c) Anwenden eines Silankopplungsmittels auf der mit der Legierung plattierten Kupferfolie, wobei das erste Metall mindestens eines ist, das aus der Gruppe, bestehend aus Nickel (Ni), Cobalt (Co), Niob (Nb), Kupfer (Cu), Zink (Zn) und Molybdän (Mo) ausgewählt ist,
das zweite Metall Zink (Zn) oder Zinn (Sn) ist, das dritte Metall Chrom (Cr) ist und ein Konzentrationsverhältnis des ersten Metalls, des zweiten Metalls und des dritten Metalls, die in der Plattierungslösung enthalten sind, 0,5 bis 3:0,5 bis 3:2 bis 7 beträgt.

2. Verfahren nach Anspruch 1, wobei der Schritt a) ferner vor der Bildung des Knötchens das Waschen der Oberfläche der Kupferfolie umfasst.

3. Gewalzte Kupferfolie, die durch das Verfahren nach einem der Ansprüche 1 bis 2 oberflächenbehandelt wurde.

4. Kupferplattiertes Laminat, umfassend die gewalzte Kupferfolie nach Anspruch 3.

## Revendications

1. Procédé de traitement en surface d'une feuille de cuivre enroulée, le procédé comprenant les étapes de :
a) formation d'un nodule sur une surface de la feuille de cuivre enroulée ;
b) introduction de la feuille de cuivre ayant dessus le nodule à une solution de placage comprenant un premier métal ayant une résistance à la chaleur, un deuxième métal ayant une résistance chimique et un troisième métal ayant une propriété anticorrosive pour réaliser le placage d'alliage ; et
c) application de la feuille de cuivre plaquée d'alliage avec un agent de couplage de silane, dans lequel le premier métal est au moins un choisi dans le groupe constitué par le nickel (Ni), le cobalt (Co), le niobium (Nb), le cuivre (Cu), le zinc (Zn), et le molybdène (Mo),
le deuxième métal est le zinc (Zn) ou l'étain (Sn),
le troisième métal est le chrome (Cr), et
un rapport de concentration du premier métal, du deuxième métal et du troisième métal compris dans la solution de placage est de 0,5 à 3 : 0,5 à 3 : 2 à 7.

2. Procédé selon la revendication 1, dans lequel l'étape a) comprend en outre, avant la formation du nodule, le lavage de la surface de la feuille de cuivre.

3. Feuille de cuivre enroulée traitée en surface par le procédé selon l'une quelconque des revendications 1 ou 2.

4. Stratifié revêtu de cuivre comprenant :
la feuille de cuivre enroulée selon la revendication 3.
